Europäisches Patentamt

European Patent Office

Office européen des brevets

(19)

(11) **EP 1 135 855 B1**

(12) **FASCICULE DE BREVET EUROPEEN**

(45) Date de publication et mention
de la délivrance du brevet:
**11.09.2002 Bulletin 2002/37**

(21) Numéro de dépôt: **99954080.0**

(22) Date de dépôt: **08.11.1999**

(51) Int Cl.⁷: **H03H 17/06**, H03H 17/02

(86) Numéro de dépôt international:
**PCT/FR99/02724**

(87) Numéro de publication internationale:
**WO 00/028662 (18.05.2000 Gazette 2000/20)**

(54) **FILTRE NUMERIQUE A ARCHITECTURE PARALLELE ET RECEPTEUR DE SIGNAUX A ETALEMENT DE SPECTRE UTILISANT UN TEL FILTRE**

DIGITALES FILTER MIT PARALLELER ARCHITEKTUR UND SPREIZSPEKTRUMEMPFÄNGER MIT EINEM SOLCHEN FILTER

DIGITAL FILTER WITH PARALLEL ARCHITECTURE AND SPREAD-SPECTRUM SIGNAL RECEIVER USING SAME

(84) Etats contractants désignés:
**DE FR GB IT**

(30) Priorité: **09.11.1998 FR 9814071**

(43) Date de publication de la demande:
**26.09.2001 Bulletin 2001/39**

(73) Titulaire: **COMMISSARIAT A L'ENERGIE ATOMIQUE
75752 Paris Cédex 15 (FR)**

(72) Inventeurs:
• **LEVEQUE, Sebastien
F-38000 Grenoble (FR)**
• **DANIELE, Norbert
F-38330 Montbonnot (FR)**
• **LATTARD, Didier
F-38680 Rencurel (FR)**
• **PIAGET, Bernard
F-38610 Venon (FR)**

(74) Mandataire: **Signore, Robert et al
c/o BREVATOME
3, rue du Docteur Lanceraux
75008 Paris (FR)**

(56) Documents cités:
**WO-A-93/23924          DE-C- 19 627 305
US-A- 4 852 035**

EP 1 135 855 B1

## Description

### Domaine technique

La présente invention a pour objet un filtre numérique à architecture parallèle et un récepteur de signaux à étalement de spectre utilisant un tel filtre.

Le filtre de l'invention peut être utilisé dans toute technique où le débit d'information est élevé, mais il est particulièrement adapté aux transmissions numériques à étalement de spectre par séquence directe où il peut servir de filtre adapté. L'invention trouve donc une application particulière dans les réseaux locaux sans fil (WLAN), dans les boucles locales d'abonnés sans fil (WLL), en téléphonie mobile, en domotique et télécollecte, en communication dans les transports, en télévision câblée et en service multimédia sur les réseaux câblés, etc...

### Etat de la technique antérieure

La technique d'étalement de spectre consiste à moduler un symbole numérique à transmettre par une séquence pseudo-aléatoire connue de l'utilisateur. Chaque séquence est composée de N éléments appelés "chips", dont la durée est le N$^{ième}$ de la durée d'un symbole. Il en résulte un signal dont le spectre s'étale sur une plage N fois plus large que celle du signal original. A la réception, la démodulation consiste à corréler le signal reçu avec la séquence utilisée à l'émission pour retrouver le symbole de départ.

Les avantages de cette technique sont nombreux :

- discrétion, puisque la puissance du signal émis étant constante et répartie dans une bande N fois plus large, sa densité spectrale de puissance est réduite d'un facteur N ;
- immunité vis-à-vis des émissions à bande étroite volontaires ou parasites, l'opération de corrélation réalisée au niveau du récepteur conduisant à l'étalement spectral de ces émissions ;
- difficulté d'interception (pour les rapports signal à bruits usuels), puisque la démodulation requiert la connaissance de la séquence utilisée à l'émission ;
- résistance aux trajets multiples qui, sous certaines conditions, provoquent des évanouissements sélectifs en fréquence et donc n'affectent que partiellement le signal émis ;
- possibilité d'un accès multiple à répartition par les codes (AMRC) ou CDMA en anglais pour "Code Division Multiple Access" : plusieurs liaisons à étalement de spectre par séquence directe peuvent partager la même bande de fréquence en utilisant des codes d'étalement orthogonaux.

On peut trouver une description de cette technique dans deux ouvrages généraux :

- Andrew J. VITERBI : "CDMA-Principles of Spread Spectrum Communication", Addison-Wesley Wireless Communications Series, 1975,
- John G. PROAKIS : "Digital Communications", Mc-Graw-Hill International Editions, 3ème édition, 1995.

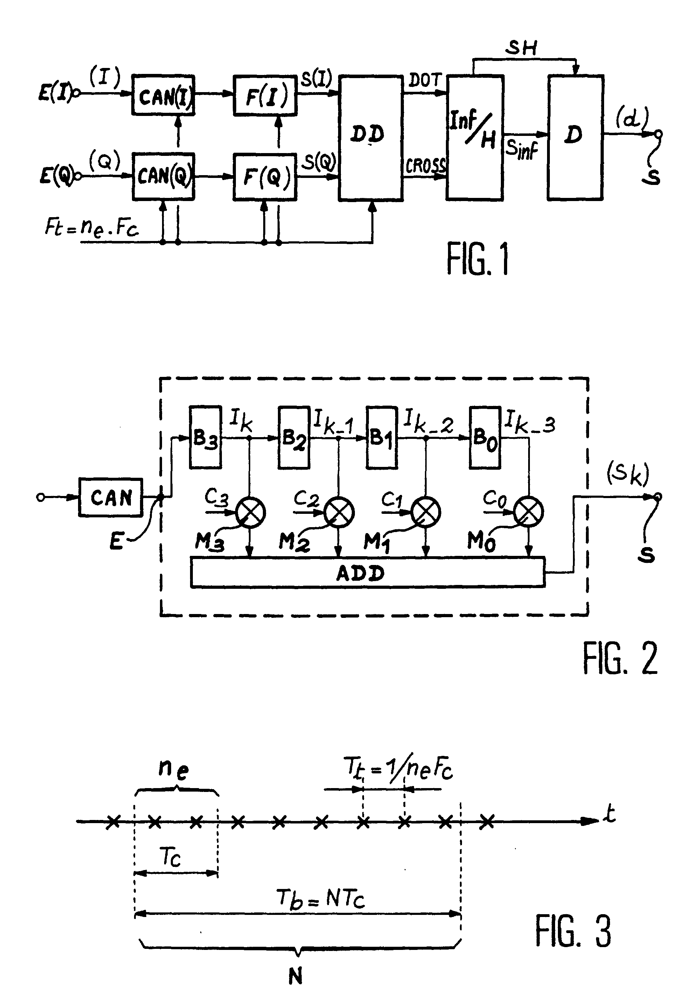

La figure 1 annexée illustre la structure générale d'un récepteur de signaux à étalement de spectre par séquence directe. A titre d'exemple, on suppose que la modulation effectuée à l'émission est une modulation différentielle de phase. Le récepteur de la figure 1 comporte deux voies en parallèle, repérées par des indices I et Q, pour le traitement d'un signal en phase avec la porteuse et d'un signal en quadrature de phase avec celle-ci. Le récepteur comprend ainsi deux entrées E(I), E(Q), deux convertisseurs analogique-numérique CAN(I), CAN(Q), deux filtres adaptés F(I), F(Q) délivrant deux signaux S(I), S(Q), un circuit DD de démodulation différentielle délivrant deux signaux traditionnellement notés "DOT" et "CROSS" (qui sont des sommes ou des différences de produits d'échantillons), un circuit Inf/H, restituant un signal d'information Sinf et un signal d'horloge SH, et enfin un circuit de décision D dont la sortie S restitue les données d.

Chaque filtre adapté F(I), F(Q) réalise une opération de corrélation entre le signal reçu et la séquence pseudo-aléatoire utilisée à l'émission. Cette opération consiste à mémoriser un certain nombre d'échantillons successifs et à effectuer une somme pondérée à l'aide de coefficients de pondération qui sont les coefficients du filtre numérique. Dans le cas particulier de l'étalement de spectre à séquence directe, utilisant des séquences binaires, ces coefficients sont égaux à +1 et à -1, selon le signe des chips formant la séquence pseudo-aléatoire.

Les convertisseurs analogique-numérique CAN(I) et CAN(Q) fonctionnent à la fréquence $F_t = n_e F_c$ où $F_c$ est la fréquence des chips ($F_c = 1/T_c$), $n_e$ est le nombre d'échantillons pris dans une période chip ($T_c$) et N le nombre de chips dans chaque séquence. Le nombre d'échantillons mémorisés est égal à $n_e N$. Pour simplifier l'exposé on supposera que l'on prend un échantillon par chip. Le nombre d'échantillons pris en compte et de coefficients est donc égal à N.

L'opération de corrélation consiste à multiplier les échantillons retenus, notés $I_{k-j}$, où k est un indice temporel et j un décalage par rapport à cet indice, avec autant de coefficients notés $C_{N-1-j}$ et à faire la somme de ces produits soit :

$$C_{N-1}I_k + C_{N-2}I_{k-1} + .....+C_0I_{k-(N-1)}$$

que l'on peut écrire :

$$S_k = \sum_{j=0}^{N-1} C_{N-1-j}I_{k-j} .$$

Cette somme pondérée est obtenue à chaque période d'échantillonnage et dépend donc de l'indice k. Le signal $S_k$ représente le signal de corrélation recherché. En général, il présente un pic très marqué lorsque tous les échantillons pris en compte correspondent aux chips de la séquence pseudo-aléatoire utilisée à l'émission.

La figure 2 montre un circuit, appelé filtre adapté, apte à produire le signal $S_k$. L'exemple illustré correspond au cas simple où N=4. Tel que représenté ce circuit comprend une entrée E reliée à un convertisseur analogique-numérique CAN, un registre à décalage formé de quatre bascules $B_0,B_1,B_2,B_3$, quatre multiplieurs $M_0,M_1, M_2, M_3$ recevant, d'une part, les quatre échantillons $I_k, I_{k-1}, I_{k-2}, I_{k-3}$, mémorisés dans les bascules et les quatre coefficients $C_3, C_2, C_1, C_0$ que l'on connaît par hypothèse.

Ce filtre comprend en outre un additionneur ADD qui forme la somme des produits partiels délivrés par les multiplieurs. La sortie générale S délivre le signal désiré $S_k$.

Si l'on prend $n_e$ échantillons au lieu d'un seul par période chip, les considérations précédentes restent valables, si ce n'est que le nombre total d'échantillons à prendre en compte devient $n_e N$ au lieu de N. Le nombre de coefficients doit, lui aussi, être égal à $n_e N$, mais avec $n_e$ répétitions pour les échantillons situés dans une même période chip ($T_c$). Par exemple, pour une séquence pseudo-aléatoire de 31 chips, et pour deux échantillons par chip, on aura 2x31=62 échantillons à prendre en compte avec 62 coefficients formés de 31 paires de coefficients égaux : $C_{61}=C_{60}$, $C_{59}=C_{58}$, ..., $C_1=C_0$. Mais l'on formera toujours une somme pondérée, en l'occurrence :

$$S_k = C_{61}I_k + C_{60}I_{k-1}+.....+C_1I_{k-60} + C_0I_{k-61}$$

Le schéma de la figure 3 illustre les instants d'échantillonnage dans le cas de deux échantillons par période chip. Ces instants sont marqués par des croix réparties sur un axe temporel. Ils sont séparés par une période de travail $T_t$ égale à $1/n_eF_c$. La période $T_b$ est égale à N fois $T_c$ et représente la durée d'un bit de données (dans le cas illustré N=4). Plusieurs bits peuvent constituer un symbole, selon les modulations choisies.

Dans une telle technique, la vitesse de traitement est directement liée au produit $DxNxn_e$ où D est le débit en données transmises. Cette quantité est une fréquence, appelée fréquence de fonctionnement (ou fréquence de travail). Plus la longueur N de la séquence pseudo-aléatoire est grande, meilleurs sont le gain de traitement, la résistance aux perturbateurs, la discrétion de la liaison et la robustesse de cette dernière face à une éventuelle interception. Pour tirer parti au mieux de ces avantages, la modulation à étalement de spectre par séquence directe doit utiliser des longueurs de séquences de quelques dizaines de chips au minimum.

De plus, le comportement d'un système à étalement de spectre par séquence directe, dans un environnement multi-trajets, dépend de sa résolution temporelle, laquelle est égale, au mieux, à la durée $T_c$ d'un chip. Plus la résolution temporelle est élevée plus $T_c$ est petite, plus il sera possible de séparer des trajets de propagation et ainsi d'augmenter l'ordre de diversité. Il est donc intéressant de disposer d'une fréquence chip élevée.

La tendance actuelle étant, en outre, d'augmenter le débit des données, on comprend que la fréquence de fonctionnement des moyens de traitement va toujours croissant. Mais cette croissance trouve sa limite dans la technologie des composants employés. Dans l'état actuel de la technique, on doit donc adopter certains compromis entre les performances souhaitées (grande vitesse de traitement) et les possibilités des circuits. Ces compromis varient selon les constructeurs :

- chez HARRIS, le composant HFA3824, fonctionne aux environs de 44 MHz avec des séquences de 11 à 16 chips et avec deux échantillons par chip. Ainsi, HARRIS obtient jusqu'à 4 Mbits/s avec une séquence de 11 chips et une modulation QPSK ("Quaternary Phase Shift Keying" utilisant 2 bits par symbole). Le nouveau composant HFA3860 permet d'atteindre 11 Mbits/s par le biais d'une modulation plus complexe (8 bits par symbole) et des séquences de longueur 8 seulement (sa fréquence de travail reste de 44 MHz).

- chez STANFORD TELECOM, le composant STEL2000A travaille sensiblement à la même vitesse (45 MHz). Il permet des liaisons jusqu'à 2 Mbits/s avec des séquences de 11 chips et deux échantillons par chip.

- chez SIRIUS COMMUNICATION, le composant SC2001 fonctionne à 47 MHz et traite jusqu'à huit échantillons par chip et utilise des séquences de 1 à 1023 chips de long. Le débit binaire maximum atteint avec une séquence de longueur minimale est de 11,75 Mbits/s.

- Le présent Demandeur a développé lui-même un circuit de traitement travaillant à une vitesse de 65 MHz. Il traite jusqu'à 16 échantillons par chip pour des séquences de longueur minimale et autorise l'utilisation de séquences de 4 à 64 chips de long. Le débit binaire maximum atteint 32,5 Mbits/s pour des séquences de longueur 4, avec un échantillon par chip.

Cet exposé de l'état de la technique montre que, pour atteindre des débits binaires supérieurs à 10 Mbits/s, l'homme de l'art propose deux solutions : soit d'utiliser une modulation plus complexe, qui augmente le nombre de bits par symbole, tout en traitant des longueurs de séquences relativement courtes (solution HARRIS avec des séquences de longueur 8), soit réduire la longueur de la séquence pour avoir un débit compatible avec la fréquence maximum de travail imposée par la technologie (65 MHz pour le présent Demandeur).

La présente invention permet d'aller au-delà de ces compromis grâce à l'utilisation d'un filtre à architecture parallèle. Elle permet ainsi d'exploiter au mieux les avantages de l'étalement de spectre grâce à l'utilisation de séquences pseudo-aléatoires longues, tout en autorisant des débits élevés.

Des filtres à architecture parallèle sont déjà connus. Par exemple, le document DE-A-196 27 305 décrit un filtre à plusieurs voies travaillant avec une pluralité de coefficients, ces coefficients étant exploités par permutation circulaire.

Un tel filtre n'est pas adapté à l'étalement de spectre à séquences longues. La présente invention propose au contraire un filtre dont la structure permet une sommation pondérée particulière, adaptée à cette technique.

**Exposé de l'invention**

Le filtre de l'invention comprend plusieurs voies et, dans chaque voie, plusieurs étages et il est structuré pour produire des signaux intermédiaires qui sont des sommes pondérées particulières des signaux d'entrée et pour produire des signaux sommes de ces signaux intermédiaires afin d'obtenir les signaux filtrés recherchés.

De façon plus précise, la présente invention a pour un objet un filtre numérique à architecture parallèle recevant p signaux d'entrée ($I_0$, ..., $I_i$, ..., $I_{p-1}$) et délivrant p signaux de sortie ($S_0$, ..., $S_i$, ..., $S_{p-1}$) qui sont des sommes des signaux d'entrée pondérés par M coefficients ($C_0$, $C_1$, ..., $C_{M-1}$), ce filtre comprenant p voies en parallèle ($V_0$, ..., $V_i$, ..., $V_{p-1}$) recevant les p signaux d'entrée ($I_0$, ..., $I_i$, ..., $I_{p-1}$), caractérisé en ce qu'il comprend r+1 étages ($E_0$, ..., $E_j$, ..., $E_r$), où r est la partie entière du rapport (M+p-2)/p, l'étage de rang j délivrant p signaux intermédiaires ($R_0^j$, ..., $R_i^j$, ..., $R_{p-1}^j$) qui sont des sommes pondérées des signaux d'entrée définies par :

$$R_i^j = \sum_{q=0}^{p-1} (C_{M-1-q+i-jp}) I_{q+jp} \, ,$$

le filtre comprenant en outre des moyens de sommation (E) recevant lesdits signaux intermédiaires ($R_i^j$) et délivrant p sommes définies par :

$$S_i = \sum_{j=0}^{r} R_i^j \, ,$$

ces p sommes constituant les p signaux de sortie ($S_0$, ..., $S_i$, ..., $S_{p-1}$).

Comme le filtre comprend p voies travaillant à une fréquence réduite d'un facteur p par rapport à la fréquence de l'ensemble à technologie donnée, à fréquence de fonctionnement donnée et à longueur de séquence fixée, le débit des données traitées par l'ensemble du filtre de l'invention est multiplié par p.

Dans un mode de réalisation, le nombre p de voies est égal à 2. Le filtre comprend alors une première voie avec des premiers moyens de mémorisation des échantillons de rang pair et une deuxième voie avec des seconds moyens de mémorisation des échantillons de rang impair, chaque voie comprenant en outre respectivement des premiers et des seconds moyens pour calculer respectivement des sommes pondérées respectivement paire et impaire.

La présente invention a également pour objet un récepteur de signaux à étalement de spectre par séquence directe comprenant :

- au moins un convertisseur analogique-numérique recevant un signal à étalement de spectre et délivrant des échantillons numériques de ce signal,
- au moins un filtre numérique ayant des coefficients adaptés à la séquence d'étalement de spectre, ce filtre recevant les échantillons délivrés par le convertisseur numérique-analogique et délivrant un signal filtré,
- des moyens de traitement du signal filtré aptes à restituer des données transmises,

ce récepteur étant caractérisé en ce que le filtre numérique est le filtre défini plus haut.

**Brève description des dessins**

- la figure 1, déjà décrite, montre un récepteur connu pour signaux à étalement de spectre ;
- la figure 2, déjà décrite, montre un filtre numérique connu ;
- la figure 3, déjà décrite, est un diagramme temporel montrant les instants d'échantillonnage dans un filtre connu ;
- les figures 4A, 4B, 4C illustrent un filtre numérique simplifié à architecture parallèle selon l'invention ;
- la figure 5 illustre des moyens pour séparer les échantillons pairs et impairs ;
- la figure 6 est un diagramme temporel montrant les instants d'échantillonnage et illustrant la réduction de fréquence de travail liée à l'architecture parallèle ;
- la figure 7 montre des moyens de sortie du filtre destinés à composer un signal filtré unique ;
- la figure 8 illustre la chronologie des signaux de sortie et leur entrelacement pour former le signal filtré unique ;
- la figure 9 illustre un mode particulier de réalisation du filtre à l'aide de bascules à sorties complémentaires et de multiplexeurs ;
- la figure 10 montre, schématiquement, un récepteur à deux voies (I,Q) utilisant un filtre à architecture parallèle selon l'invention dans chaque voie ;
- la figure 11 montre les deux paires de signaux délivrés par les filtres des deux voies ;
- la figure 12 montre l'architecture du filtre dans le cas général de p voies ;
- la figure 13 montre la structure d'un des étages ;
- la figure 14 illustre un mode particulier de réalisation des moyens pour sommer les signaux intermédiaires ;
- la figure 15 illustre un cas particulier du filtre pour p=2 et M=7.

**Description détaillée de modes particuliers de réalisation**

Dans la description qui suit, on commencera par supposer que le nombre p de voies est égal à 2. On généralisera ensuite au cas où p est quelconque.

Pour illustrer le principe du filtre de l'invention, on considérera encore le cas très simple de séquences pseudo-aléatoires comprenant quatre chips avec un seul échantillon par chip, comme pour l'exposé de l'état de la technique. Il va sans dire que, dans la pratique, la séquence comprendra beaucoup plus de chips et que plusieurs échantillons pourront être pris dans une période chip.

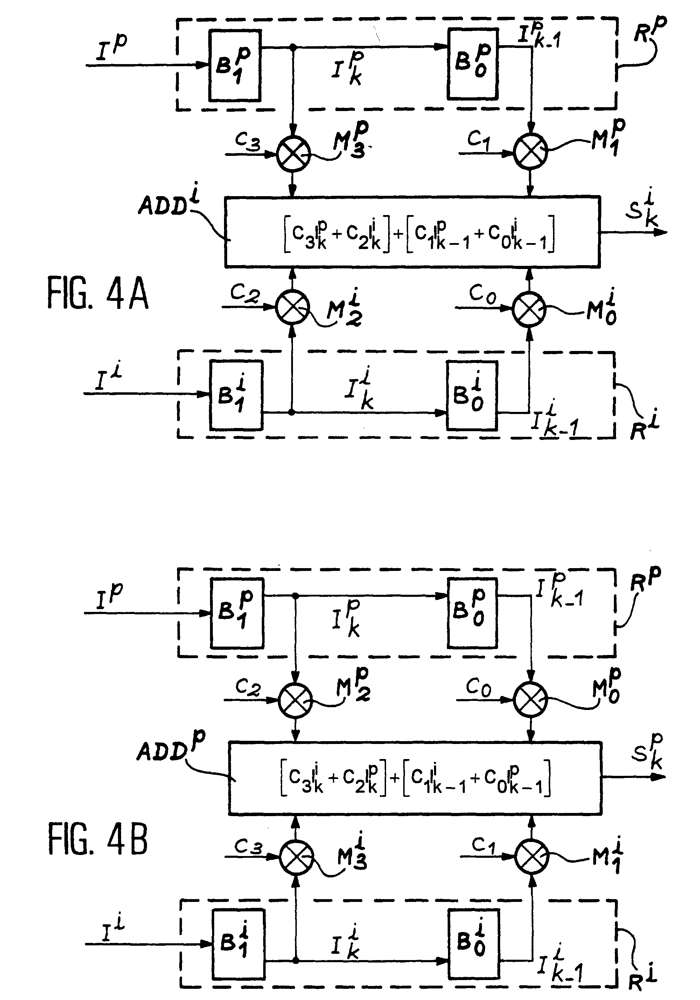

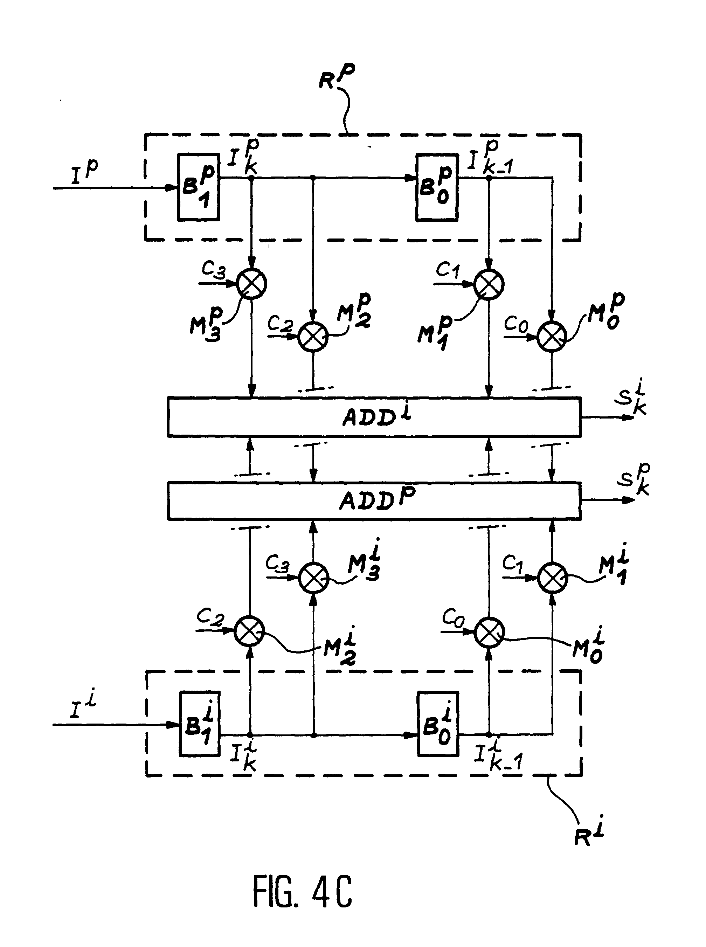

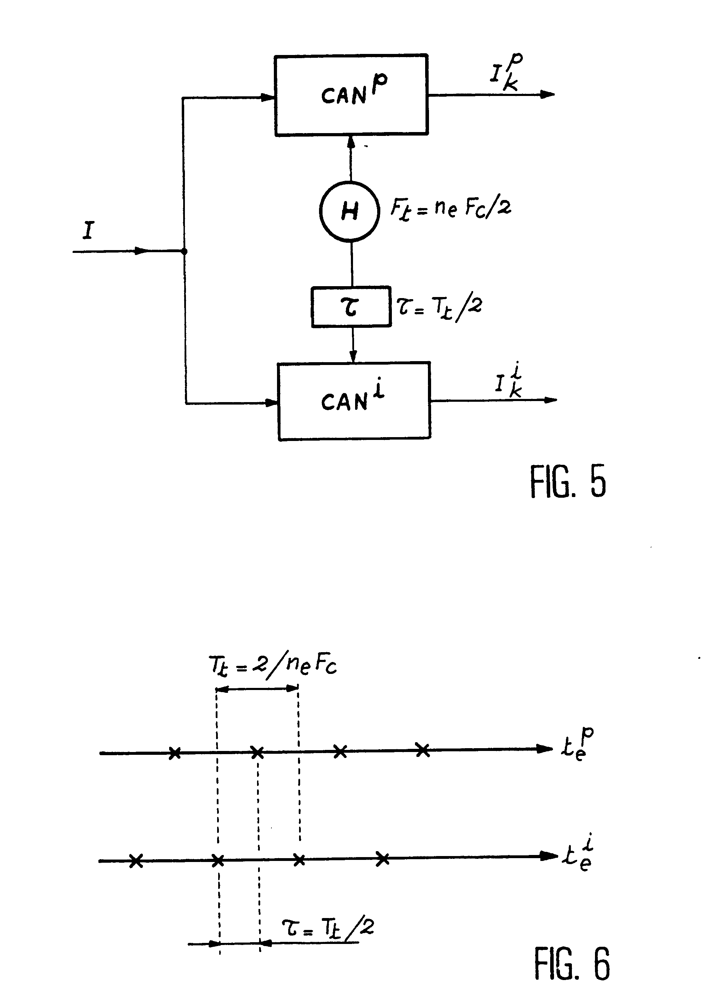

Les figures 4A et 4B représentent deux circuits fictifs correspondants à des situations paire et impaire et la figure 4C le circuit réel obtenu par fusion de ces deux circuits fictifs. Sur toutes ces figures, les premiers moyens de mémorisation comprennent un premier registre RP à deux bascules $B_0^p, B_1^p$ aptes à mémoriser deux échantillons pairs, respectivement $I_{k-1}^p, I_k^p$ et les seconds moyens de mémorisation comprennent un second registre $R^i$ à deux bascules $B_0^i, B_1^i$ aptes à mémoriser deux échantillons impairs, respectivement $I_{k-1}^i, I_k^i$. Ces deux registres sont alimentés par des échantillons respectivement pairs $I^p$ et impairs $I^i$ obtenus par des moyens qui seront décrits ultérieurement en liaison avec la figure 5. Le filtre représenté comprend également des multiplieurs pairs $M_0^p, M_1^p, M_2^p, M_3^p$ et des multiplieurs impairs $M_0^i, M_1^i, M_2^i, M_3^i$ et deux additionneurs pair et impair ADDp, ADDi.

Lorsque, dans les quatre échantillons pris en compte, l'échantillon le plus ancien est impair (à savoir $I_{k-1}^i$) le filtre doit être apte à former la somme pondérée $S_k^i$ suivante :

$$S_k^i = C_3 I_k^p + C_2 I_k^i + C_1 I_{k-1}^p + C_0 I_{k-1}^i \qquad (1)$$

soit :

$$S_k^i = \sum_{j=0}^{1}\left[C_{3-2j}I_{k-j}^p + C_{2-2j}I_{k-j-1}^i\right] \qquad (2)$$

A l'instant d'échantillonnage suivant, l'échantillon le plus ancien devient pair et la somme pondérée à calculer devient $S_k^p$ :

$$S_k^p = C_3 I_k^i + C_2 I_k^p + C_1 I_{k-1}^i + C_0 I_{k-1}^p \qquad (3)$$

soit :

$$S_k^p = \sum_{j=0}^{1}\left[C_{3-2j}I_{k-j}^i + C_{2-2j}I_{k-j}^p\right] \qquad (4)$$

Il faut donc que les registres, pair et impair, soient combinés à deux jeux différents de multiplieurs et d'additionneurs pour que les sommes pondérées $S_k^i$ et $S_k^p$ puissent être calculées alternativement. La figure 4A montre les moyens aptes à calculer la première somme pondérée $S_k^i$. Les échantillons pairs sont pondérés par les coefficients $C_3$ et $C_1$ tandis que les échantillons impairs sont pondérés par les coefficients $C_2$ et $C_0$. Sur la figure 4B, les échantillons pairs sont multipliés, cette fois, par les coefficients $C_2$ et $C_0$ tandis que les échantillons impairs sont multipliés par $C_3$ et $C_1$ et l'on obtient la seconde somme pondérée $S_k^p$.

Le filtre complet doit donc se présenter comme illustré sur la figure 4C, avec quatre multiplieurs pairs $M_3^p, M_2^p, M_1^p, M_0^p$ reliés au registre pair $R^p$ et quatre multiplieurs impairs $M_3^i, M_2^i, M_1^i, M_0^i$ reliés au registre impair $R^i$. Deux additionneurs $ADD^i, ADD^p$ reliés chacun à quatre multiplieurs alternativement pairs et impairs complètent le registre. Ces deux additionneurs délivrent les signaux de corrélation $S_k^i$ et $S_k^p$.

Pour former les deux flux d'échantillons pairs et impairs alimentant respectivement les registres pair et impair, on peut utiliser les moyens représentés sur la figure 5. Il s'agit de deux convertisseurs analogique-numérique, respectivement pair $CAN^p$ et impair $CAN^i$, recevant un même signal I. Ces convertisseurs sont commandés par deux signaux issus d'une horloge H travaillant à la fréquence de travail $F_t$ égale à $n_e F_c/2$, l'un étant décalé par rapport à l'autre d'une demi-période, soit $\tau = T_t/2 = 1/n_e F_c$.

Le diagramme de la figure 6 montre les instants d'échantillonnage $t_e^p$ et $t_e^i$ pour le convertisseur pair $CAN^p$ et pour le convertisseur impair $CAN^i$. Deux séries d'échantillons sont ainsi obtenues, avec des échantillons espacés de la période de travail $T_t = 2/n_e F_c$, ces deux séries étant décalées l'une de l'autre, de la quantité $T_t/2$. Globalement, on a donc toujours un échantillonnage à la fréquence $n_0 F_c$, mais au niveau des composants utilisés dans chaque voie, on travaille à la fréquence moitié. La comparaison avec la figure 3 déjà décrite fait immédiatement apparaître que le recours à l'architecture parallèle divise par 2 la fréquence de travail des composants.

La comparaison entre la figure 4C et la figure 2 montre également que le filtre de l'invention possède le même nombre de bascules qu'un filtre de l'art antérieur, mais deux fois plus de multiplieurs et deux additionneurs au lieu d'un seul. Cette augmentation du nombre de composants est largement compensée par l'augmentation du débit de données, autrement dit de la diminution de la fréquence de travail (facteur 2).

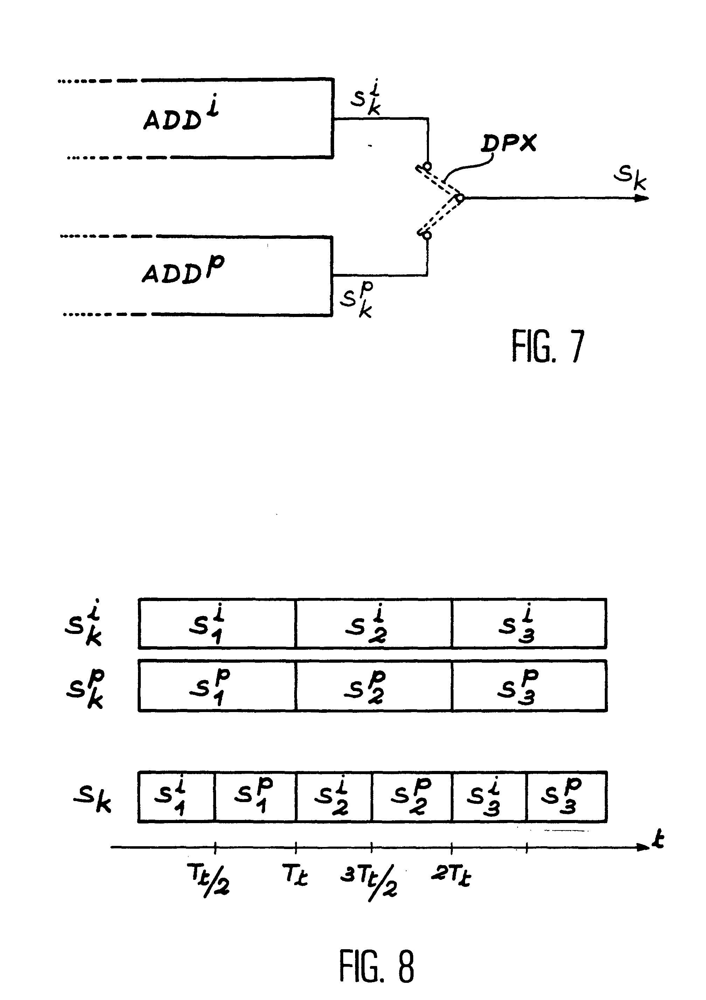

Reste, éventuellement, à combiner les deux signaux obtenus en sortie des additionneurs $ADD^i$ et $ADD^p$. La figure 7 montre qu'il suffit pour cela d'un duplexeur DPX prenant alternativement l'une des sommes $S_k^i$ puis l'autre $S_k^p$ pour obtenir un signal filtré unique $S_k$.

Le diagramme de la figure 8 montre la chronologie des premières sommes pondérées $S_k^i$ et secondes sommes pondérées $S_k^p$ et la somme combinée Sk. A chaque demi-période $T_t/2 = 1/n_e F_c$, on obtient la valeur de la somme pondérée comme pour un filtre séquentiel qui travaillerait à la fréquence $n_e F_c$.

Naturellement, le cas N=4 et $n_e=1$ n'est guère réaliste et ne sert qu'à exposer l'invention. Dans la pratique, chaque registre possédera $N x n_e/2$ bascules et il existera $2 x N x n_e$ multiplieurs et $N n_e$ coefficients de pondération (N groupes de $n_e$). On peut donner l'expression générale des sommes à calculer en posant M=Nxne. Les sommes pondérées $S_k^p$ et $S_k^i$ sont légèrement différentes selon que M est pair ou impair :

**1) M impair**

Le filtre calcule les deux quantités suivantes :

$$S_k^p = \sum_{j=0}^{(M-1)/2} \left[ C_{M-1-2j} \cdot I_{k-j}^i + C_{M-2-2j} \cdot I_{k-j}^p \right] \qquad (5)$$

$$S_k^i = \sum_{j=0}^{(M-1)/2} \left[ C_{M-1-2j} \cdot I_{k-j}^p + C_{M-2-2j} \cdot I_{k-j-1}^i \right] \qquad (6)$$

**2) M pair :**

Le filtre calcule les deux quantités suivantes :

$$S_k^p = \sum_{j=0}^{(M-2)/2} \left[ C_{M-1-2j} \cdot I_{k-j}^i + C_{M-2-2j} \cdot I_{k-j}^p \right] \qquad (7)$$

$$S_k^i = \sum_{j=0}^{(M-2)/2} \left[ C_{M-1-2j} \cdot I_{k-j}^p + C_{M-2-2j} \cdot I_{k-j-1}^i \right] \qquad (8)$$

En prenant M=4, N=4 et $n_e$=1, on retrouve l'exemple des figures 4A pour $S_k^i$ et 4B pour $S_k^p$ et les relations (2) et (4).

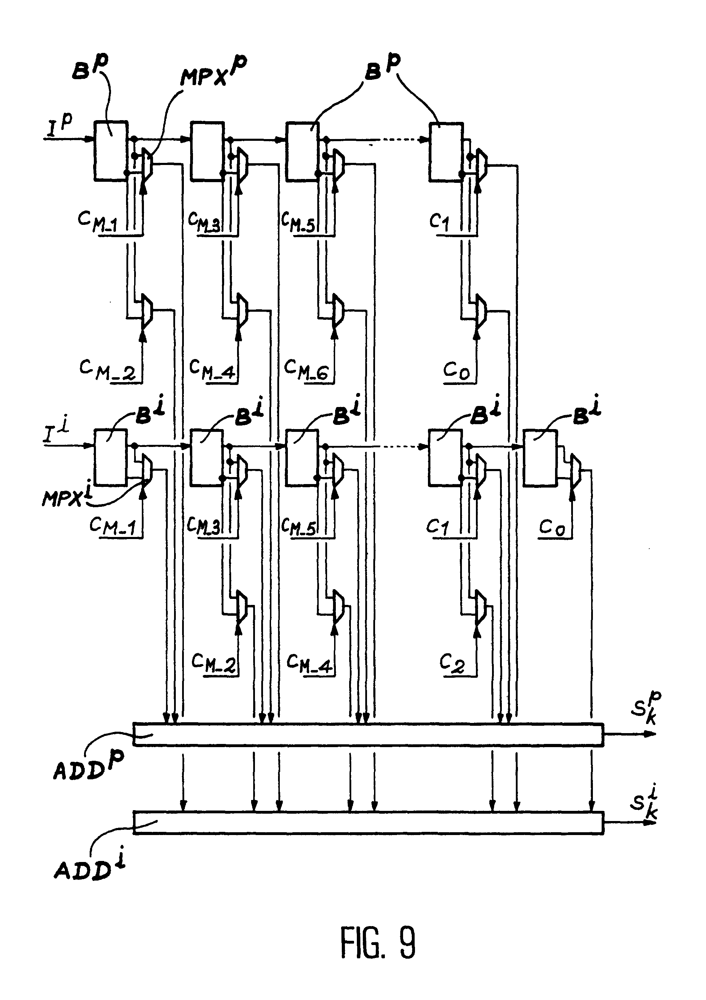

Dans le mode de réalisation de la figure 4C, les multiplieurs sont représentés par des moyens recevant, d'une part, l'échantillon et, d'autre part, le coefficient multiplicatif-. Dans l'application à l'étalement de spectre et des séquences d'étalement binaires les coefficients du filtre ne sont pas quelconques mais reflètent le signe des chips constituant la séquence pseudo-aléatoire. Ces coefficients sont donc égaux à +1 ou à -1. Les multiplieurs peuvent alors prendre une forme particulière puisqu'il s'agit simplement de multiplier chaque échantillon par +1 ou par -1. On peut alors faire usage de bascules et de multiplieurs d'un type particulier comme illustré sur la figure 9. On voit que chaque registre à décalage comprend des cellules $B^p$ ou $B^i$ avec une entrée D et une sortie directe Q, l'entrée D étant reliée à la sortie directe Q de la bascule qui précède et la sortie directe Q étant reliée à l'entrée D de la bascule qui suit. Chaque bascule comprenant en outre une sortie complémentée $\bar{Q}$. Des multiplexeurs $MPX^p$, $MPX^i$ ont deux entrées reliées respectivement aux sorties directe Q et complémentée $\bar{Q}$ des bascules correspondantes, et une entrée de commande recevant un signal de commande positif ou négatif. Les sorties des multiplexeurs sont connectées aux additionneurs $ADD^p$ et $ADD^i$.

Le schéma de la figure 9 correspond au cas où le nombre M est impair. Il y a donc une bascule de plus dans la voie impaire que dans la voie paire. Les M coefficients sont notés $C_{M-1}$, $C_{M-2}$, ..., $C_1$, $C_0$. Si le nombre $n_e$ d'échantillons par chip était différent de l'unité, ces coefficients seraient égaux par paquets de $n_e$.

Sur la figure 9, les voies sont représentées horizontalement. On peut distinguer, verticalement, des étages englobant les dispositifs à retard. Avec deux signaux d'entrée (pairs et impairs) donc p=2 et en prenant M=4 par exemple, on a trois étages, plus un dernier dispositif à retard. Ces considérations seront généralisées par la suite.

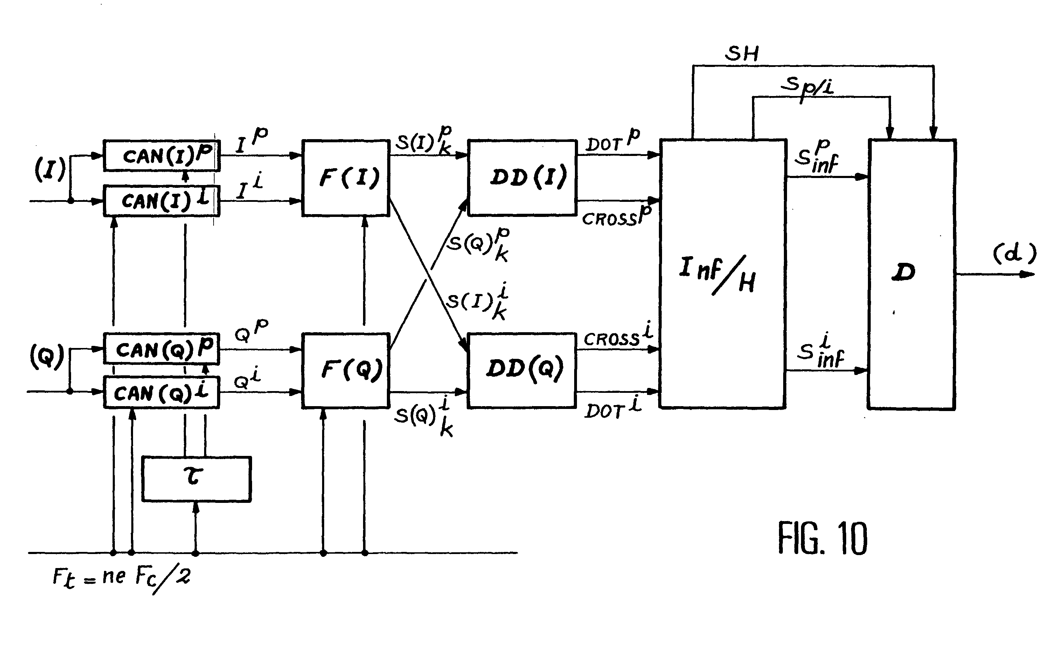

Le filtre qui vient d'être décrit peut être utilisé avantageusement dans les récepteurs de signaux à étalement de spectre et, en particulier, dans les récepteurs à deux voies, l'une pour le traitement du signal en phase avec la porteuse et l'autre pour le traitement du signal en quadrature de phase avec ladite porteuse. Ce mode de réalisation correspond aux modulations différentielles de phase (à deux états de phase ou plus). La figure 10 montre ainsi, schématiquement, un tel récepteur. Tel que représenté, il comprend :

- dans la voie I, deux convertisseurs analogique-numérique $CAN(I)^p$, $CAN(I)^i$ commandés à la fréquence $n_e F_c/2$ et décalés de $\tau=1/n_e F_c$ comme décrit à propos de la figure 5, et un filtre numérique F(I) à architecture parallèle tel que décrit plus haut ;
- dans la voie Q, les moyens sont similaires, à savoir deux convertisseurs analogique-numérique $CAN(Q)^p$, $CAN(Q)^i$, un filtre numérique à architecture parallèle F(Q) délivrant les signaux de filtrage pair $S(Q)_k^p$ et impair $S(Q)_k^p$.

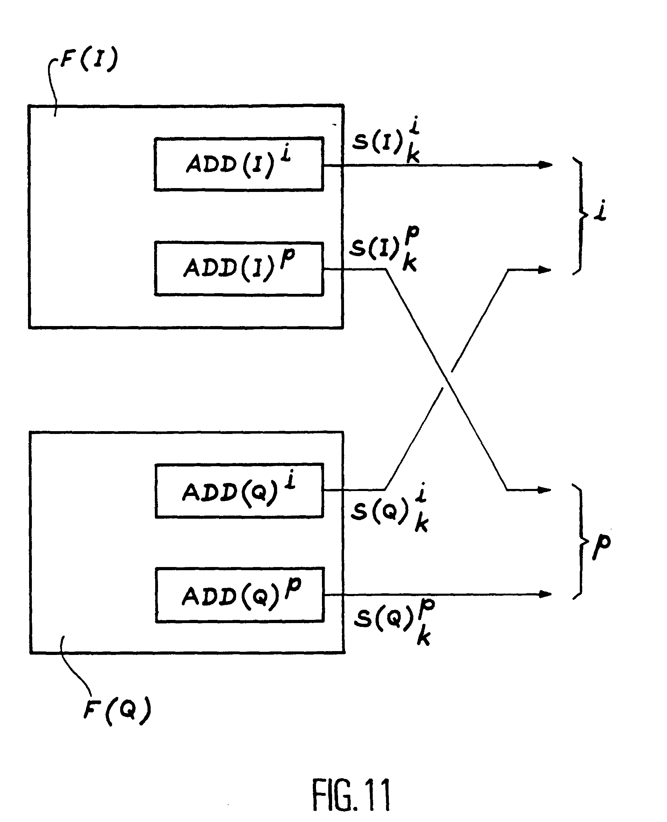

Dans la variante illustrée, on utilise directement les signaux de filtrage pair $S(I)_k^p$ et impair $S(Q)_k^i$ délivrés par les deux additionneurs pair et impair du filtre, sans recombiner ces signaux en un signal unique. La figure 11 permet de préciser cette question :

- dans la voie I, le filtre F(I) comprend deux additionneurs $ADD(I)^i$ et $ADD(I)^p$ délivrant les sommes pondérées $S(I)_k^j$ et $S(I)_k^p$ ;
- dans la voie Q, le filtre F(Q) comprend deux additionneurs $ADD(Q)^i$ et $ADD(Q)^p$ délivrant les sommes pondérées $S(Q)_k^i$ et $S(Q)_k^p$.

Revenant à la figure 10, le récepteur comprend encore deux circuits de démodulation différentielle DD(I), DD(Q), le premier recevant les premières sommes pondérées (paires), soit $S(I)_k^p$ et $S(Q)_k^p$ et le second les secondes sommes pondérées (impaires), soit $S(I)_k^i$ et $S(Q)_k^i$. Chacun de ces circuits délivre des signaux DOT et CROSS, à savoir des premiers signaux $DOT^p$ et $CROSS^p$ pour le premier et des seconds signaux $DOT^i$ et $CROSS^i$ pour le second. On rappelle qu'un signal DOT est égal à $I_k I_{k-1} + Q_k Q_{k-1}$ et un signal CROSS à $Q_k I_{k-1} - I_k Q_{k-1}$ si $I_k$ et $Q_k$ désignent les signaux de rang k issus des voies I et Q.

Le récepteur comprend encore un circuit Inf/H qui reçoit les divers signaux DOT et CROSS et délivre des premiers et seconds signaux d'information $S_{inf}^p$ et $S_{inf}^i$ iinf, un signal de parité Sp/i et un signal d'horloge SH déterminé à partir des pics de corrélation.

Le récepteur comprend enfin un circuit de décision D qui reçoit les premiers et seconds signaux d'information $S_{inf}^p$, $S_{inf}^i$, le signal de parité Sp/i, qui permet de les distinguer et le signal d'horloge SH qui permet de restituer l'information. Ces derniers circuits sont semblables à ceux des récepteurs classiques si ce n'est qu'ils distinguent les pics des premiers et seconds signaux DOT et CROSS, grâce au signal de parité Sp/i.

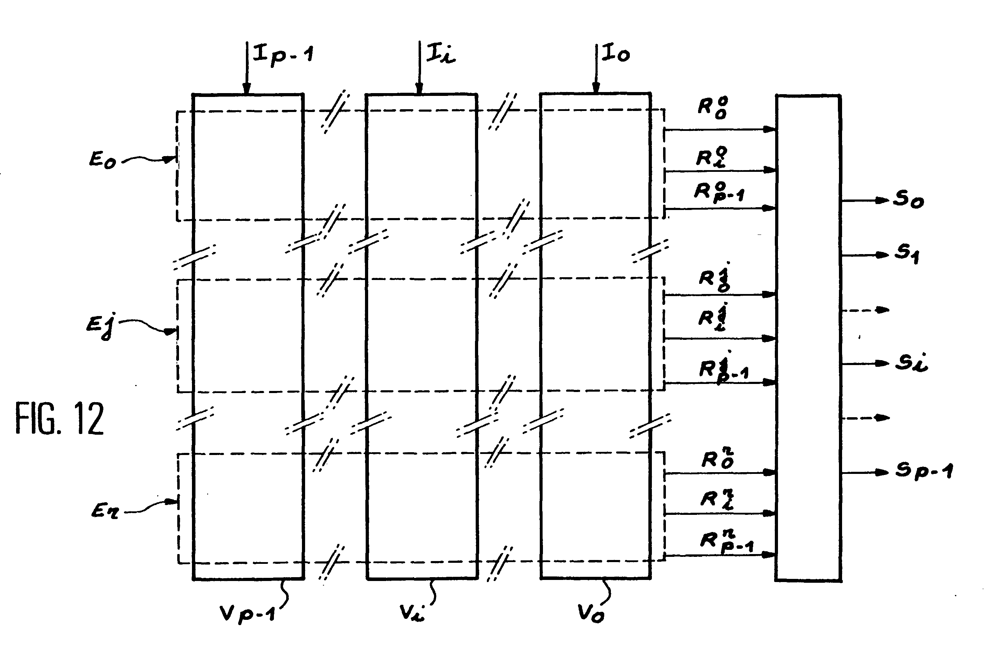

Les figures 12, 13 et 14 généralisent la description qui vient d'être faite au cas de p voies en parallèle, p étant quelconque.

La figure 12 illustre tout d'abord la structure générale du filtre avec p voies en parallèle $V_0$, ..., $V_i$, ..., $V_{p-1}$ (on notera que ces voies sont représentées verticalement à la différence des figures 4A, 4B, 4C pour des raisons de commodité), et r+1 étages, le nombre r étant la partie entière de la quantité (M+p-2)/p. Par exemple si M=4 et p=2, on a r=2, donc trois étages, comme c'était le cas pour la figure 9 déjà décrite.

Les p signaux d'entrée $I_0$, ..., $I_i$, ..., $I_{p-1}$ sont appliqués aux p voies. Ces signaux sont retardés chacun de $1/F_t$ où $F_t$ est la fréquence travail. Les étages délivrent des signaux intermédiaires notés R avec un indice bas i repérant le numéro de la voie (de 0 à p-1) et un indice haut j repérant le rang de l'étage (de 0 à r). Ainsi, l'étage $E_j$ délivre p signaux intermédiaires $R_i^j$, i allant de 0 à p-1, selon la relation :

$$R_i^j = \sum_{q=0}^{p-1} (C_{M-1-q+i-jp}) I_{q+jp} \cdot$$

Le coefficient de pondération, que l'on peut noter Cx où x est l'indice, doit être pris égal à zéro si x<0 ou si $x \geq M$. Autrement dit, les coefficients vont de $C_0$ à $C_{M-1}$.

Le filtre comprend en outre des moyens de sommation $\sum$ recevant les signaux intermédiaires $R_i^j$ et délivrant p sommes définies par :

$$S_i = \sum_{j=0}^{r} R_i^j \, ,$$

ces p sommes constituant p signaux de sortie $S_0$, ..., $S_i$, ..., $S_{p-1}$ pour le filtre (avec seulement deux voies, on obtient deux signaux de sortie, appelés dans la première partie de la description, signaux pairs et impairs).

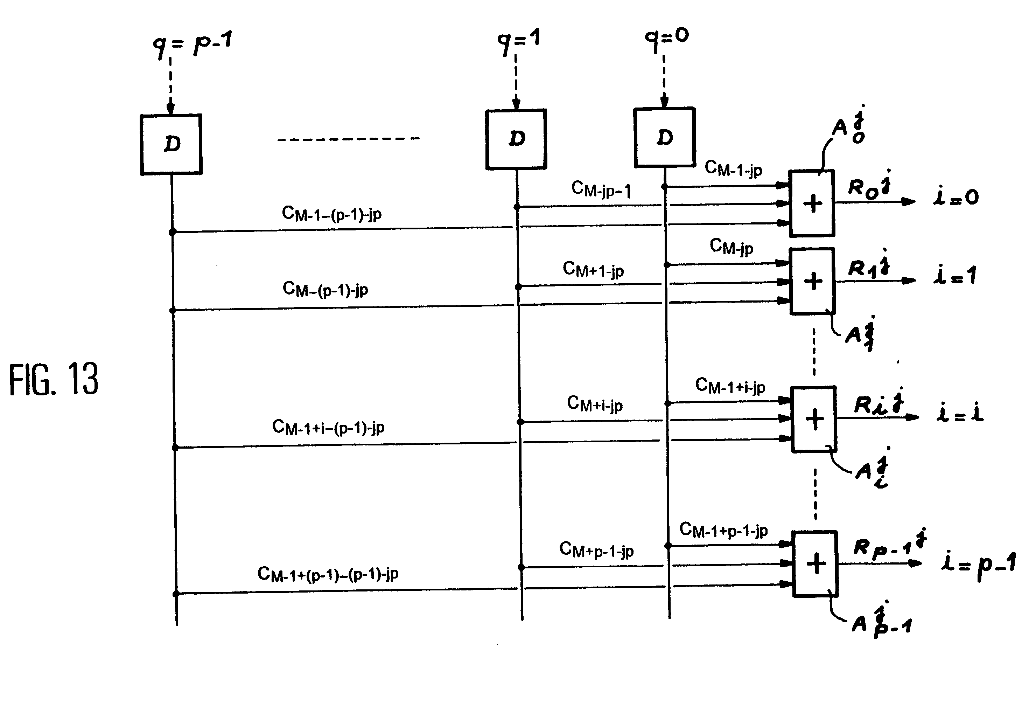

La figure 13 montre un mode de réalisation de l'étage de rang j. Sur cette figure, les p carrés notés D sont des circuits à retard et les lettres C indicées sont des coefficients par lesquels on pondère les signaux. Pour simplifier la figure, les multiplieurs ne sont pas représentés expressément ce qui signifie que le signal véhiculé par une connexion est pondéré par le coefficient marqué au-dessus de cette connexion.

On voit ainsi que les p signaux délivrés par les p circuits à retard sont d'abord multipliés par les coefficients $C_{M-1-jp}$, ..., $C_{M-1-(p-1)-jp}$ et que les p signaux ainsi pondérés sont additionnés dans un additionneur $A_0^j$ pour obtenir un premier signal intermédiaire $R_0^j$ :

$$R_0^j = \sum_{q=0}^{p-1} (\bar{C}_{M-1-q-jp}).I_{q+jp} \ .$$

La formation de ces signaux intermédiaires se reproduit ainsi avec les coefficients $C_{M-jp}$, ..., $C_{M+(p-1)-jp}$ et l'additionneur $A_1^j$, avec les coefficients $C_{M-1+i-jp}$, ..., $C_{M-1+i-(p-1)-jp}$ et l'additionneur $A_1^j$, etc..., les coefficients $C_{M-1-p-1-jp}$, ..., $C_{M-1-(p-1)+(p-1)-jp}$ et l'additionneur $A_{p1}^j$ .

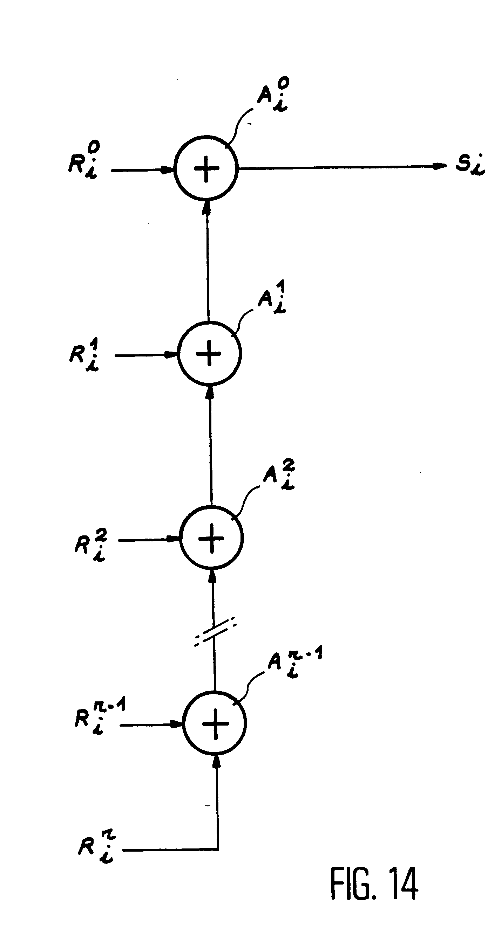

La figure 14, enfin, illustre un mode de réalisation d'une partie des moyens de sommation $\Sigma$. S'agissant d'obtenir le signal de sortie Si défini par :

$$S_i = \sum_{j=0}^{r} R_i^j \ ,$$

on additionne tous les signaux intermédiaires ayant même indice i, à l'aide de r additionneurs $A_i^0, A_i^1, ..., A_i^j, ..., A_i^{r-1}$ connectés en série et recevant respectivement les signaux intermédiaires $R_i^0, R_i^1, ..., R_i^j, ..., R_i^r$.

Pour illustrer le passage du cas général à certains cas particuliers on peut prendre par exemple le cas où p est égal à 2. La valeur des signaux intermédiaires est alors :

$$R_i^j = \sum_{q=0}^{1} (C_{M-1-q+i-2j}) I_{q+2j}$$

Par ailleurs, en prenant M=7 la valeur des signaux intermédiaires devient :

$$R_i^j = \sum_{q=0}^{1} (C_{6-q+i-2j}) I_{q+2j}$$

soit

$$R_i^j = (C_{6+i-2j}) I_{2j} + (C_{5+i-2j}) I_{1+2j}.$$

Le nombre r est égal à la partie entière de (M+p-2)/2 soit 3. Il y a donc 4 étages.

L'indice i prend deux valeurs 0 et 1 et les signaux intermédiaires prennent les expressions :

$$R_0^j = (C_{6-2j}) I_{2j} + (C_{5-2j}) I_{1+2j}$$

$$R_1^j = (C_{7-2j}) I_{2j} + (C_{6-2j}) I_{1+2j}.$$

Les signaux de sortie ont donc pour valeur :

$$S_0 = \sum_{j=0}^{3} R_0^j = R_0^0 + R_0^1 + R_0^2 + R_0^3$$

$$S_1 = \sum_{j=0}^{3} R_1^j = R_1^0 + R_1^1 + R_1^2 + R_1^3 \, .$$

Soit respectivement :

$$S_0 = C_6 I_0 + C_5 I_1$$

$$+ C_4 I_2 + C_3 I_3$$

$$+ C_2 I_4 + C_1 I_5$$

$$+ C_0 I_6 + 0.I_7$$

et

$$S_1 = O.I_0 + C_6 I_1$$

$$+ C_5 I_2 + C_4 I_3$$

$$+ C_3 I_4 + C_2 I_5$$

$$+ C_1 I_6 + C_0 I_7$$

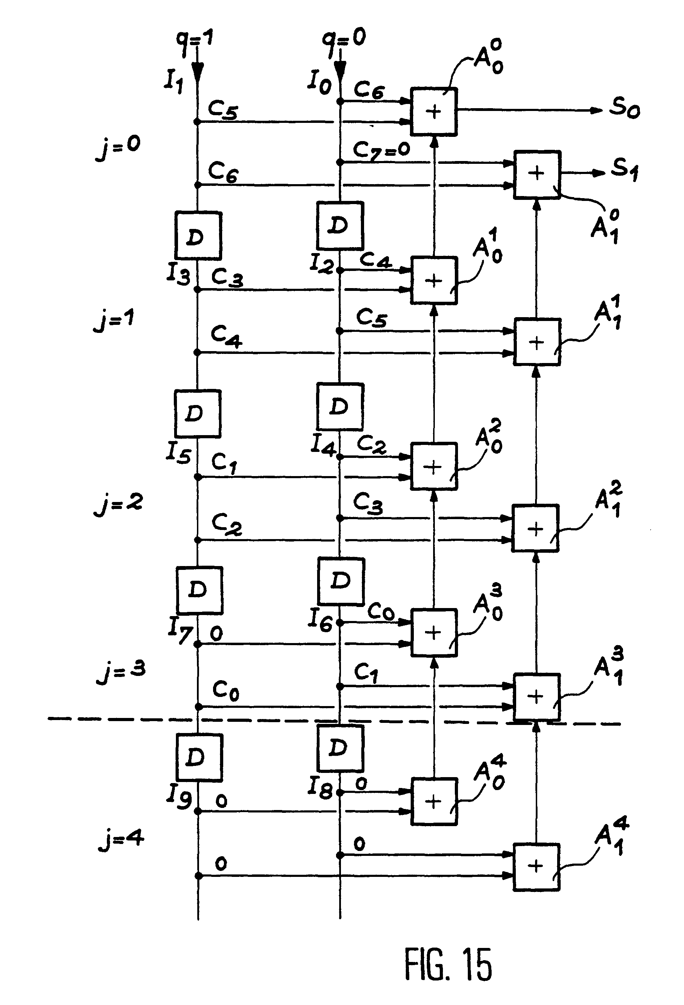

La figure 15 illustre le filtre correspondant avec ses deux voies (q=0, q=l) ses quatre étages (j=0 à j=3) (l'étage j=4 est forcé à zéro), ses deux signaux d'entrée $I_0$, $I_1$, ses deux signaux de sortie $S_0$, $S_1$ et ses sept coefficients $C_0$, $C_1$, ..., $C_6$ (les coefficients d'indice égal à 7 et au-delà ou négatif sont nuls).

## Revendications

1. Filtre numérique à architecture parallèle recevant p signaux d'entrée ($I_0$,..., $I_i$,..., $I_{p-1}$) et délivrant p signaux de sortie ($S_0$,..., $S_i$,..., $S_{p-1}$) qui sont des sommes des signaux d'entrée pondérés par M coefficients ($C_0$, $C_1$, ..., $C_{M-1}$), ce filtre comprenant p voies en parallèle ($V_0$, ..., $V_i$,..., $V_{p-1}$) recevant les p signaux d'entrée ($I_0$,..., $I_i$,..., $I_{p-1}$), **caractérisé en ce qu'**il comprend r+1 étages ($E_0$, ..., $E_j$, ..., $E_r$), où r est la partie entière du rapport (M+p-2)/2, l'étage de rang j délivrant p signaux intermédiaires ($R_0^j$,..., $R_i^j$,..., $R_{p-1}^j$) qui sont des sommes pondérées des signaux d'entrée définies par :

$$R_i^j = \sum_{q=0}^{p-1} (C_{M-1-q+i-jp}) I_{q+jp} \, ,$$

le filtre comprenant en outre des moyens de sommation ($\Sigma$) recevant lesdits signaux intermédiaires ($R_i^j$) et délivrant p sommes définies par :

$$S_i = \sum_{j=0}^{r} R_i^j \, ,$$

ces p sommes constituant les p signaux de sortie ($S_0$, ..., $S_i$, ..., $S_{p-1}$).

**2.** Filtre numérique selon la revendication 1, dans lequel le nombre p de voies est égal à 2, le filtre comprenant alors une première voie avec des premiers moyens ($R^p$) de mémorisation des échantillons de rang pair ($I^p_k$, $I^{pi}_{k-1}$,...) et une deuxième voie avec des seconds moyens ($R^i$) de mémorisation des échantillons de rang impair ($I^i_k$, $I^i_{k-1}$,...), chaque voie comprenant en outre respectivement des premiers ($M^p_0$, $M^p_1$,...,$ADD^p$) et des seconds ($M^i_0$, $M^i_1$ $M$,..., $ADD^i$) moyens pour calculer respectivement des sommes pondérées respectivement paire ($S^p_k$) et impaire ($S^i_k$).

**3.** Filtre selon la revendication 2, dans lequel les premiers et seconds moyens pour calculer les sommes pondérées paire et impaire comprennent chacun des multiplieurs ($M^p_1$, $M^p_3$..., $M^i_0$, $M^i_2$...) recevant chacun un échantillon ($I^p_k$, $I^p_{k-1}$...,$I^i_{k-1}$, $I^i_k$...) et un coefficient de pondération ($C_1$, $C_3$, $C_0$, $C_2$) ($C_0$, $C_2$, $C_1$, $C_3$), et un additionneur ($ADD^i$, $ADD^p$) relié aux multiplieurs.

**4.** Filtre selon la revendication 2, dans lequel les premiers et seconds moyens de mémorisation comprennent chacun, respectivement, un premier ($R^p$) et un second ($R^i$) registre à décalage.

**5.** Filtre selon la revendication 4, dans lequel chaque registre à décalage ($R^p$,$R^i$) comprend des cellules ($B^p$) ($B^i$) constituées chacune d'une bascule avec une entrée (D) et une sortie directe (Q), l'entrée d'une bascule étant reliée à la sortie directe (Q) de la bascule qui précède et la sortie directe (Q) d'une bascule étant reliée à l'entrée de la bascule qui suit, chaque bascule comprenant en outre une sortie complémentée ($\bar{Q}$), les multiplieurs étant alors des multiplexeurs ($MPX^p$) ($MPX^i$) à deux entrées reliées respectivement aux sorties directe (Q) et complémentée ($\bar{Q}$) des bascules, chaque multiplieur comprenant en outre une entrée de commande recevant un signal de commande positif ou négatif ($C_0$, $C_1$, ..., $C_{M-1}$) et une sortie, laquelle se trouve reliée soit à l'une des entrées, soit à l'autre, selon le signe du signal de commande.

**6.** Récepteur pour signaux à étalement de spectre par séquence directe comprenant :

- au moins un convertisseur analogique-numérique (CAN(I), CAN(Q)) recevant un signal à étalement de spectre et délivrant des échantillons numériques de ce signal,
- au moins un filtre numérique (F(I), F(Q)) ayant des coefficients ($C_j$) adaptés à la séquence d'étalement de spectre, ce filtre recevant les échantillons délivrés par le convertisseur numérique-analogique et délivrant un signal filtré,
- des moyens (DD, Inf/H, D) de traitement du signal filtré aptes à restituer des données transmises (d),

ce récepteur étant **caractérisé en ce que** le filtre numérique (F(I), F(Q)) est un filtre numérique à architecture parallèle conforme à l'une quelconque des revendications 1 à 5.

**7.** Récepteur selon la revendication 6, comprenant une première et une seconde voies en parallèle, la première (I) pour le traitement d'un signal en phase avec une porteuse et la seconde (Q) pour le traitement d'un signal en quadrature de phase avec ladite porteuse, chaque voie comprenant ledit filtre numérique (F(I), F(Q)) à architecture parallèle avec, pour la première voie (I), notamment, un premier et un second additionneurs ($ADD(I)^p$, $ADD(I)^i$) délivrant des première et seconde sommes pondérées ($S(I)^p_k$,$S(I)^i_k$) et, pour la seconde voie (Q), notamment, un premier et un second additionneurs ($ADD(Q)^p$, $ADD(Q)^i$) délivrant des première et seconde sommes pondérées ($S(Q)^p_k$) ($S(Q)^i_k$).

**8.** Récepteur selon la revendication 7, dans lequel les moyens de traitement comprennent, dans la première voie (I), un premier circuit de démodulation différentielle (DD(I)) et, dans la seconde voie (Q), un second circuit de démodulation différentielle (DD(Q)), le premier circuit de démodulation différentielle (DD(I)) recevant les premières sommes pondérées ($S(I)^p_k$,$S(Q)^p_k$) délivrées par les filtres (F(I), F(Q)) de la première et de la seconde voie (I), (Q) et délivrant deux premiers signaux DOT et CROSS ($DOT^p$, $CROSS^p$), le second circuit de démodulation différentielle (DD(Q)) recevant les secondes sommes pondérées ($S(I)^i_k$) et ($S(Q)^i_k$) délivrées par les filtres (F(I),F(Q)) de la première et de la seconde voies (I, Q) et délivrant deux seconds signaux DOT et CROSS ($DOT^i$, $CROSS^i$).

**9.** Récepteur selon la revendication 8, dans lequel les moyens de traitement comprennent en outre un circuit d'information et d'horloge (Inf/H) recevant les signaux ($DOT^p$, $CROSS^p$) ($DOT^i$, $CROSS^i$) délivrés par le premier et le second circuits de démodulation différentielle (DOT(I), DD(Q)) et délivrant deux signaux d'information pair et impair ($S^p_{inf}$, $S^i_{inf}$), un signal d'horloge (SH) et un signal de parité (Sp/i).

**Patentansprüche**

1.  Digitales Filter mit paralleler Architektur, das p Eingangssignale ($I_0$, ..., $I_i$, ..., $I_{p-1}$) empfängt und p Ausgangssignale ($S_0$, ..., $S_i$, ..., $S_{p-1}$) liefert, die Summen der Eingangssignale sind, gewichtet durch M Koeffizienten ($C_0$, $C_1$, ..., $C_{M-1}$), wobei dieses Filter p parallele Kanäle ($V_0$, ..., $V_i$, ..., $V_{p-1}$) umfasst, die die p Eingangssignale ($I_0$, ..., $I_i$, ..., $I_{p-1}$) empfangen,
    **dadurch gekennzeichnet,**
    **dass** es r+1 Stufen ($E_0$, ..., $E_j$, ..., $E_r$) umfasst, wo r der ganze Teil des Verhältnisses (M+p-2)/2 ist, und die Stufe des Rangs j p Zwischensignale ($R_0^j$, ..., $R_i^j$, ..., $R_{p-1}^{\ j}$) liefert, die gewichtete Summen der Eingangssignale sind, definiert durch:

$$R_i^j = \sum_{q=0}^{p-1} (C_{M-1-q+i-jp}) I_{q+jp},$$

    wobei das Filter außerdem Summiereinrichtungen ($\Sigma$) umfasst, die die Zwischensignale ($R_i^j$) empfangen und p Summen liefern, definiert durch:

$$S_i = \sum_{j=0}^{r} R_i^j,$$

    wobei diese p Summen die p Ausgangssignale ($S_0$, ..., $S_i$, ..., $S_{p-1}$) bilden.

2.  Digitales Filter nach Anspruch 1, bei dem die Anzahl von p Kanälen gleich zwei ist, so dass dieses Filter dann einen ersten Kanal mit ersten Einrichtungen ($R^p$) zur Speicherung der Abtastwerte geraden Rangs ($I_k^p$, $I_{k-1}^p$, ...) und einen zweiten Kanal mit zweiten Einrichtungen (R') zur Speicherung der Abtastwerte ungeraden Rangs ($I_k^i$, $I_{k-1}^i$, ....) umfasst, jeder Kanal außerdem jeweils erste ($M_0^p$, $M_1^p$, ..., $ADD^p$) und zweite ($M_0^i$, $M_1^i$, ..., $ADD^i$) Einrichtungen umfasst, um jeweils gerade $S_k^p$ beziehungsweise ungerade $S_k^i$ gewichtete Summen zu berechnen.

3.  Filter nach Anspruch 2, bei dem jede der ersten und zweiten Einrichtungen zum Berechnen der geraden und ungeraden gewichteten Summen einen Multiplizierer ($M_1^p$, $M_3^p$, ..., $M_0^i$, $M_2^i$ ....) umfassen, von denen jeder einen Abtastwert $I_{k-1}^p$, $I_k^p$ ..., $I_{k-1}^i$, $I_k^i$ ...) und einen Gewichtungskoeffizienten ($C_1$, $C_3$, $C_0$, $C_2$) ($C_0$, $C_2$, $C_1$, $C_3$) empfängt, und einen Addierer ($ADD^i$, $ADD^p$), verbunden mit den Multiplizierern.

4.  Filter nach Anspruch 2, bei dem jede der ersten und zweiten Speichereinrichtungen jeweils ein erstes ($R^p$) und ein zweites ($R^i$) Schieberegister umfassen.

5.  Filter nach Anspruch 2, bei dem jedes Schieberegister ($R^p$, $R^i$) Zellen ($B^p$) ($B^i$) umfasst, von denen jede durch ein Kippglied mit einem Eingang (D) und einem direkten Ausgang (Q) gebildet wird, wobei der Eingang eines Kippglieds mit dem direkten Ausgang (Q) des vorangehenden Kippglieds verbunden ist, und der direkte Ausgang (Q) eines Kippglieds mit dem Eingang des nachfolgenden Kippglieds verbunden ist, und jedes Kippglied außerdem einen komplementierten Ausgang ($\bar{Q}$) umfasst, wobei die Multiplizierer dann Multiplexer ($MPX^p$) ($MPX^i$) mit zwei Eingängen sind, jeweils verbunden mit den direkten (Q) und komplementierten ($\bar{Q}$) Ausgängen des Kippglieds, und jeder Multiplizierer außerdem einen Steuereingang umfasst, der ein positives oder negatives Steuersignal ($C_0$, $C_1$, ..., $C_{M-1}$) empfängt, und einen Ausgang, der entweder mit dem einen oder dem anderen der Eingänge verbunden ist, je nach Vorzeichen des Steuersignals.

6.  Direktsequenz-Spreizspektrumsignalempfänger, umfassend:

    -   wenigstens einen Analog-Digital-Wandler (CAN(I), CAN(Q)), der ein Spreizspektrumsignal empfängt und digitale Abtastwerte dieses Signals liefert,
    -   wenigstens ein digitales Filter (F(I), F(Q)) mit Koeffizienten ($C_j$), angepasst an die Spreizspektrumsequenz, wobei dieses Filter die durch den Analog-Digital-Wandler gelieferten Abtastwerte empfängt und ein gefiltertes Signal liefert,
    -   Verarbeitungseinrichtungen (DD, Inf/H, D) des gefilterten Signals, fähig übertragene Daten (d) wiederzugeben,

dabei ist dieser Empfänger **dadurch gekennzeichnet, dass** das digitale Filter (F(I), F(Q)) ein digitales Filter mit paralleler Architektur nach einem der Ansprüche 1 bis 5 ist.

7. Empfänger nach Anspruch 6, zwei parallele Kanäle umfassend, einen ersten (I) zum Verarbeiten eines mit einem Träger phasengleichen Signals und einen zweiten (Q) zum Verarbeiten eines zu demselben Träger um 90° phasenverschobenen Signals, wobei jeder Kanal das genannte digitale Filter (F(I), F(Q)) mit paralleler Architektur umfasst, mit - bezogen auf den ersten Kanal (I) - einem ersten und zweiten Addierer (ADD(I)$^p$, ADD(I)$^i$), die erste und zweite gewichtete Summen (S(I)$^p_k$,S(I)$^i_k$) liefern, und - bezogen auf den zweiten Kanal (Q) - einem ersten und einen zweiten Addierer (ADD(Q)$^p$, ADD(Q)$^i$), die erste und zweite gewichtete Summen (S(Q)$^p_k$,S(Q)$^i_k$) liefern.

8. Empfänger nach Anspruch 7, bei dem die Verarbeitungseinrichtungen in dem ersten Kanal (I) eine erste Differential-Demodulationsschaltung (DD(I)) umfassen und in dem zweiten Kanal (Q) eine zweite Differential-Demodulationsschaltung (DD(Q)), wobei die erste Differential-Demodulationsschaltung (DD(I)) die durch die Filter (F(I),F(Q)) des ersten und zweiten Kanals (I, Q) gelieferten ersten gewichteten Summen (S(I)$^p_k$,S(Q)$^p_k$) empfängt und zwei erste Signale DOT und CROSS (DOT$^p$, CROSS$^p$) liefert, und die zweite Differentlal-Demodulationsschaltung (DD(Q)) die durch die Filter (F(I),F(Q)) des ersten und des zweiten Kanals (I, Q) gelieferten zweiten gewichteten Summen (S(I)$^i_k$,S(Q)$^i_k$) empfängt und zwei zweite Signale DOT und CROSS (DOT$^j$, CROSS$^j$) liefert.

9. Empfänger nach Anspruch 8, bei dem die Verarbeitungseinrichtungen außerdem eine Informations- und Taktschaltung (Inf/H) umfassen, die die Signale (DOT$^p$, CROSS$^p$) (DOT$^i$, CROSS$^i$) empfängt, die durch die erste und zweite Differential-Demodulationsschaltung (DOT(I), DD(Q)) geliefert werden, und zwei gerade und ungerade Informationssignale (S$^p_{inf}$,S$^i_{inf}$), ein Taktsignal (SH) und ein Paritätssignal (Sp/i) liefert.

**Claims**

1. A parallel architecture digital filter receiving p input signals (I$_0$, ..., I$_i$,..., I$_{p-1}$) and delivering p output signals (S$_0$, ..., S$_i$,..., S$_{p-1}$) which are the sums of input signals weighted with M coefficients (C$_0$, C$_1$,...,C$_{M-1}$), this filter comprising p parallel channels (V$_0$,...V$_i$,...,V$_{p-1}$) receiving input signals (I$_0$,..., I$_i$,...,I$_{p-1}$), **characterized in that** it comprises r+1 stages (E$_0$,..., E$_j$,...,E$_r$), where r is the integer portion of ratio (m+p-2)/2, the stage of rank j delivering p intermediate signals (R$_0^j$,...,R$_i^j$,...R$_{p-1}^j$) which are the weighted sums of input signals defined by:

$$R_i^j = \sum_{q=0}^{p-1} \left( C_{M-1-q+i-jp} \right) I_{q+jp}$$

the filter further comprising summing means (Σ) receiving said intermediate signals (R$_i^j$) and delivering p sums defined by:

$$S_i = \sum_{j=0}^{r} R_i^j$$

these p sums forming p output signals ( (S$_0$,....,S$_i$,...,S$_{p-1}$).

2. The digital filter according to claim 1, wherein the number of channels p is equal to 2, the filter then comprising a first channel with first means (R$^p$) for storing the samples of even rank (I$_k^p$, I$_{k-1}^{pi}$,...) and a second channel with second means (R$^i$) for storing the samples of odd rank (I$_k^i$, I$_{k-1}^i$,...), each channel further comprising first (M$_0^p$,..., M$_1^p$,..., ADD$^p$) and second (M$_0^i$, M$_1^i$,..., ADD$^i$) means respectively, for respectively calculating even (S$_k^p$) and odd (S$_k^i$) weighted sums, respectively.

3. The filter according to claim 2, wherein first and second means for calculating the even and odd weighted sums each comprise multipliers (M$_1^p$,M$_3^p$,...,M$_0^i$,M$_2^i$...) each receiving a sample (I$_{k-1}^p$,I$_k^p$,..., I$_{k-1}^i$,I$_k^i$...) and a weighting coefficient (C$_1$,C$_3$,C$_0$,C$_2$) (C$_0$,C$_2$,C$_1$,C$_3$), and an adder (ADD$^i$, ADD$^p$) connected to the multipliers.

4. The filter according to claim 2, wherein first and second storing means each comprise a first (R$^p$) and a second (R$^i$) shift register, respectively.

5. The filter according to claim 4, wherein each shift register ($R^p$, $R^i$) comprises cells ($B^p$) ($B^i$) each consisting of a flip-flop with a input (D) and a direct output (Q), wherein the input of a flip-flop is connected to the direct output (Q) of the preceding flip-flop and the direct output (Q) of a flip-flop is connected to the input of the next flip-flop, each flip-flop further comprising a complemented output (!Q), the multipliers then being multiplexers ($MPX^p$) ($MPX^i$) with two inputs connected to the direct (Q) and complemented (!Q) outputs of the flip-flops, respectively, each multiplier further comprising a control input receiving a positive or negative control signal ($C_0$, $C_1$, ..., $C_{m-1}$) and an output, which is either connected to one of the inputs, or to the other, according to the sign of the control signal.

6. A receiver for direct sequence spread spectrum signals comprising:

   - at least an analog/digital converter (CAN(I), CAN(Q)) receiving a spread spectrum signal and delivering digital samples of this signal,
   - at least a digital filter (F(I), F(Q)) with coefficients ($C_j$) adapted to the spread spectrum sequence, this filter receiving the samples delivered by the digital/analog converter and delivering a filtered signal,
   - means (DD, Inf/H, D) for processing the filtered signal able to restore the transmitted data (d), this receiver being **characterized in that** the digital filter (F(I), F(Q)) is a parallel architecture digital filter according to any of claims 1 to 5.

7. The receiver according to claim 6, comprising first and second channels in parallel, the first (I) for processing a signal in phase with a carrier and the second (Q) for processing a signal in phase quadrature with said carrier, each channel comprising said parallel architecture digital filter (F(I), F(Q)) with, for the first channel (I), notably, first and second adders ($ADD(I)^p$, $ADD(I)^i$) delivering first and second weighted sums ($S(I)_k^p$, $S(I)_k^i$) and, for the second channel (Q), notably, first and second adders ($ADD(Q)^p$, ($ADD(Q)^i$) delivering first and second weighted sums ($S(Q_k^p$, $S(Q)_k^i$).

8. The receiver according to claim 7, wherein the processing means comprise, in the first channel (I), a first differential demodulation circuit (DD(I)) and in the second channel (Q), a second differential demodulation circuit (DD(Q)), the first differential demodulation circuit (DD(I)) receiving the first weighted sums ($S(I)_k^p$, $S(Q)_k^p$) delivered by filters (F(I), F(Q)) of the first and second channel (I), (Q), and delivering two first DOT and CROSS signals ($DOT^p$. $CROSS^p$), the second differential demodulation circuit (DD(Q)) receiving the second weighted sums ($S(I)_k^i$) and ($S(Q)_k^i$) delivered by filters (F(I), F(Q)) of the first and second channels (I, Q) and delivering two second DOT and CROSS signals ($DOT^i$, $CROSS^i$).

9. The receiver according to claim 8, wherein the processing means further comprise a clock and an information circuit (Inf/H) receiving the ($DOT^p$, $CROSS^p$) ($DOT^i$, $CROSS^i$) signals delivered by the first and second differential demodulation circuits (DOT(I), DD(Q)) and delivering two even and odd information signals ($S_{inf}^p$), $S_{inf}^i$), a clock signal (SH) and a parity signal (Sp/i).

FIG. 1

FIG. 2

FIG. 3

$I^p$ → $B_1^p$ ··· $I_k^p$ ··· $B_0^p$ ··· $I_{k-1}^p$ ··· $R^p$

$C_3$ → $M_3^p$    $C_1$ → $M_1^p$

$ADD^i$ $\left[c_3I_k^p + c_2I_k^i\right] + \left[c_1I_{k-1}^p + c_0I_{k-1}^i\right]$ → $S_k^i$

$C_2$ → $M_2^i$    $C_0$ → $M_0^i$

$I^i$ → $B_1^i$ ··· $I_k^i$ ··· $B_0^i$ ··· $I_{k-1}^i$ ··· $R^i$

**FIG. 4A**

$I^p$ → $B_1^p$ ··· $I_k^p$ ··· $B_0^p$ ··· $I_{k-1}^p$ ··· $R^p$

$C_2$ → $M_2^p$    $C_0$ → $M_0^p$

$ADD^p$ $\left[c_3I_k^i + c_2I_k^p\right] + \left[c_1I_{k-1}^i + c_0I_{k-1}^p\right]$ → $S_k^p$

$C_3$ → $M_3^i$    $C_1$ → $M_1^i$

$I^i$ → $B_1^i$ ··· $I_k^i$ ··· $B_0^i$ ··· $I_{k-1}^i$ ··· $R^i$

**FIG. 4B**

FIG. 4 C

CAN$^P$ $\quad$ $I^P_k$

$(H)$ $\quad F_t = n_e\,F_c/2$

$\tau$ $\quad \tau = T_t/2$

$I$

CAN$^i$ $\quad$ $I^i_k$

FIG. 5

$T_t = 2/n_e\,F_c$

$t^P_e$

$t^i_e$

$\tau = T_t/2$

FIG. 6

FIG. 7

FIG. 8

FIG. 9

FIG. 10

FIG. 11

FIG. 12

$I_{p-1}$  $I_i$  $I_0$

$E_0$

$E_j$

$E_n$

$R^0_0$
$R^0_1$
$R^0_{p-1}$

$R^i_0$
$R^i_1$
$R^i_{p-1}$

$R^n_0$
$R^n_1$
$R^n_{p-1}$

$S_0$
$S_1$
$S_i$
$S_{p-1}$

$V_{p-1}$  $V_i$  $V_0$

EP 1 135 855 B1

FIG. 13

$q = p-1$

$q = 1$

$q = 0$

D

D

D

$A_0^i$

$C_{M-1-jp}$

$C_{M-jp-1}$

$R_0^i$    $i = 0$

$C_{M-1-(p-1)-jp}$

$C_{M-jp}$

$C_{M+1-jp}$

$R_1^i$    $i = 1$

$C_{M-(p-1)-jp}$

$A_1^i$

$C_{M-1+i-jp}$

$C_{M+i-jp}$

$R_i^i$    $i = i$

$C_{M-1+i-(p-1)-jp}$

$A_i^i$

$C_{M-1+p-1-jp}$

$C_{M+p-1-jp}$

$R_{p-1}^i$    $i = p-1$

$C_{M-1+(p-1)-(p-1)-jp}$

$A_{p-1}^i$

FIG. 14

FIG. 15